# EUROPEAN PATENT APPLICATION

(11) **EP 2 251 902 A1**
(43) Date of publication of application: **17.11.2010**
(21) Application number: 08873167.4
(22) Date of filing: 10.12.2008
(51) Int. Cl.: H01L 23/36, H05K 7/20

(54) **STRUCTURE FOR ATTACHING COMPONENT HAVING HEATING BODY MOUNTED THEREON**

(30) Priority: 05.03.2008 JP 2008055438
(71) Applicant: Kabushiki Kaisha Toshiba, Minato-ku Tokyo 105-8001 (JP)
(72) Inventor: HASEGAWA, Tsuyoshi, (JP)
(74) Representative: Granleese, Rhian Jane
(86) International application number: PCT/JP2008/003685
(87) International publication number: WO 2009/110045

(57) **Abstract**

The invention improves the heat radiation efficiency by improving the heat conduction efficiency after ensuring downsizing. A plurality of projections 15 are formed on a attaching surface of a base plate 10 and the base plate 10 is structured so as to be attached to a heat radiation member via a heat conduction sheet 18 formed by a softer material than that of the base plate 10.

## Description

### FIELD OF THE INVENTION

The present invention relates to an attaching structure of a component for mounting a heating element to mount a heating element such as a semiconductor element composing various electronic parts.

### BACKGROUND ART

Generally, a semiconductor apparatus is structured so that a semiconductor element composing an electronic part which is a heating element is stored and arranged in a semiconductor package which is a component for mounting a heating element and a connection terminal for external connection is protruded from the peripheral wall of the semiconductor package. Such a semiconductor package is used in the state that the connection terminal for external connection is electrically connected to a circuit of a printed circuit board. If the semiconductor element generates heat and rises in temperature due to the use of the semiconductor package, a reduction in the performance of the semiconductor element is caused. Therefore, the semiconductor package uses a method for discharging externally generated heat and keeping the temperature of the semiconductor element at the allowable value.

Therefore, for the semiconductor package, various cooling structures for efficiently discharging the heat with the use and thermally controlling the temperature of the semiconductor element to the allowable value have been developed. As such a cooling structure, a structure is proposed that the package base body is attached to a heat radiator via a graphite sheet having an excellent heat conduction efficiency, for example, thus the heat can be transferred highly efficiently (for example, refer to Patent Document 1). Further, there is another constitution available that instead of the graphite sheet, heat radiation grease is coated between the package base body and the heat radiator.
Patent Document 1: Japanese Patent Application disclosure 2004-288949

### DISCLOSURE OF THE INVENTION

### PROBLEMS TO BE SOLVED BY THE INVENTION

In the semiconductor package constitution aforementioned, the graphite sheet or heat radiation grease is arranged between attaching surfaces of the heat radiator and package base body, so that the efficiency of heat conduction can be improved. However, a problem arises that the graphite sheet and heat radiation grease cause blocking the electric conduction and a reduction in the electric performance. Further, the heat conduction efficiency between the package base body and heat radiator is decided by heat transfer areas between the package base body and the graphite sheet and between the heat radiator and the graphite sheet. Therefore, in order to further improve the heat conduction efficiency, the heat transfer area must be increased, thus a problem arises that the package base body becomes large.

Such a situation is not limited to the semiconductor package and is the same also to the various component for mounting the heating element on which a heating element such as an electronic part is mounted.

The present invention was developed in view of the above-mentioned situation and is intended to provide an attaching structure of a component for mounting a heating element of which heat radiation efficiency is improved by improving the heat conduction efficiency while downsizing of the component for mounting the heating element is maintained.

### MEANS FOR SOLVING THE PROBLEMS

An attaching structure of a component for mounting a heating element relating to the embodiments of the present invention incudes the component for mounting the heating element having a attaching surface with a plurality of projections arranged and mounting a. heating element, a heat radiation member to which the component for mounting the heating element is thermally coupled and attached, and a heat conduction sheet which is formed by a softer material than that of the component for mounting the heating element and is arranged between the attaching surface of the component for mounting the heating element and the heat radiation member.

According to the attaching structure of the component for mounting the heating element mentioned above, the component for mounting the heating element is thermally coupled with the heat radiation member via the heat conduction sheet, attached and arranged in the state that the attaching surface of the component for mounting the heating element is opposite to the heat radiation member via the heat conduction sheet and the plurality of projections are pushed into the heat conduction sheet which is materially soft.

By doing this, the heat transfer area (contact area) between the component for mounting the heating element and the heat conduction sheet is added with the surface area including the outer peripheral walls of the plurality of projections of the attaching surface, thereby can be spread without increasing the area (projected area) of the attaching surface itself. Therefore, the heat transfer area can be increased and the heat radiation efficiency can be improved, while downsizing of the component for mounting the heating element is maintained.

### EFFECTS OF THE INVENTION

As mentioned above, according to the present invention, an attaching structure of a component for mounting a heating element which improves the heat radiation efficiency while downsizing of the component for mounting the heating element is maintained can be provided.

### BRIEF DESCRIPTION OF THE DRAWINGS

Fig. 1 is a perspective view showing the external constitution of a semiconductor package to which an attaching structure of a component for mounting a heating element relating to an embodiment of the present invention is applied.
Fig. 2 is a cross sectional view showing the state that the semiconductor package shown in Fig. 1 is attached to the heat radiation member.
Fig. 3 is a plan view showing an enlarged part of the attaching surface of a base plate shown in Fig. 1.
Fig. 4 is a cross sectional view of a main section showing an enlarged part of Fig. 2.
Fig. 5 is a cross sectional view of a main section shown for explaining an attaching structure of a component for mounting a heating element relating to another embodiment of the present invention.
Fig. 6 is a cross sectional view of a main section shown for explaining an attaching structure of a component for mounting a heating element relating to still another embodiment of the present invention.
Fig. 7 is a cross sectional view of a main section shown for explaining an attaching structure of a component for mounting a heating element relating to a further embodiment of the present invention.
Fig. 8 is a cross sectional view of the main section shown for explaining an attaching structure of a component for mounting a heating element relating to a still further embodiment of the present invention.
Fig. 9 is a cross sectional view of a main section shown for explaining an attaching structure of a component for mounting a heating element relating to yet a further embodiment of the present invention.
Fig. 10 is a cross sectional view of a main section shown for explaining an attaching structure of a component for mounting a heating element relating to yet a further embodiment of the present invention.
Fig. 11 is a cross sectional view of a main section showing for explaining an attaching structure of a component for mounting a heating element relating to yet a. further embodiment of the present invention.
Fig. 12 is a cross sectional view of a main section shown for explaining an attaching structure of a component for mounting a heating element relating to yet a further embodiment of the present invention.
Fig. 13 is a cross sectional view of a main section shown for explaining an attaching structure of a component for mounting a heating element relating to yet a further embodiment of the present invention.

### DESCRIPTION OF THE NUMERALS

- 10: Base plate
- 11 10A: Attacbing surface Frame body
- 12: Semiconductor element
- 13: Lid body
- 14: Connection terminal for external connection
- 15, 51, 152, 153, 154, 155, 156: Projection
- 16: Attaching recess
- 17: Heat radiation member
- 17A: Attaching surface
- 18: Heat conduction sheet
- 20: Component for mounting heating element
- 22: Heating element
- 171, 172, 173, 174: Projection
- 181, 182, 183, 184: Projection

### DESCRIPTION OF THE PREFERRED EMBODIMENTS

Hereinafter, an attaching structure of a component for mounting a heating element relating to the embodiments of the present invention will be explained in detail with reference to the accompanying drawings.

### Embodiment 1

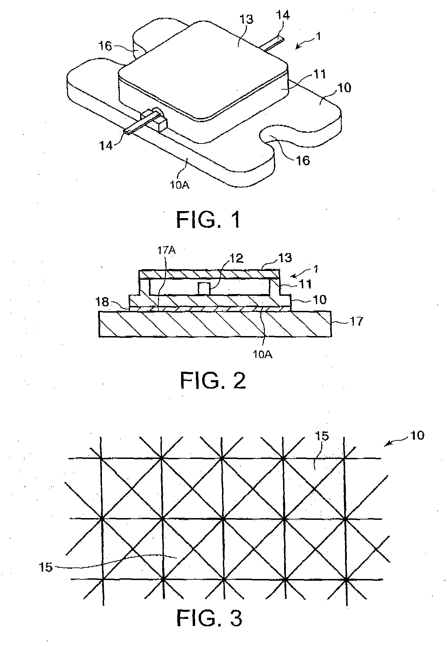

Fig. 1 shows an appearance of a semiconductor package 1 which is a component for mounting a heating element applied to an attaching structure of a component for mounting a heating element relating to an embodiment of the present invention. The base plate 10 is formed in a rectangular shape, for example, and the attaching recesses 16 are formed at both ends thereof. On one surface of the base plate 10, the frame body 11 composing an element storage portion is installed integrally. Further, the other surface of the base plate 10 composes the attaching surface 10A to which a heat radiation member is attached.

On the base plate 10 in the frame body 11, as shown in Fig. 2, the semiconductor element 72 is mounted, and on the frame body 11, the lid body 13 is attached. On both side walls of the frame body 11 which are opposite to each other, the connection terminals 14 for external connection which are electrically connected to the semiconductor element 12 are respectively projected so as to connect external.

The base plate 10, frame body 11, and lid body 13 are formed by metallic materials having excellent heat conductivity such as copper. Further, on the overall surface of the attaching surface 10A of the base plate 10, for example, a plurality of projections 15 in a quadrangular pyramid shape are formed closely (refer to Fig. 3).

The attaching recesses 16 enables an inrorted-through screw member (not shown) to screw the heat radiation member 17, for example, in the state that the semiconductor package 1 is mounted on the heat radiation member 17 via the heat conduction sheet 18 (refer to Fig. 2). The heat radiation member 17 is, for example, a heat sink composed of a metallic body and has the attaching surface 17A to which the component for mounting the heating element (the semiconductor package 1) is attached.

When the base plate 10 is, for example, formed by copper, the heat conduction sheet 18 is formed by a metallic material such as gold (Au), tin (Sn), or indium (In) or a material such as a graphite sheet or a highly polymerized heat conduction material which are softer than copper and are excellent in heat conductivity. The thickness of the heat conduction sheet 18 is set so that the heat conduction sheet 18 and the heat radiation member 17 may be adhered closely to each other in the state that the plurality of projections 15 of the base plate 10 are pushed into the heat conduction sheet 18.

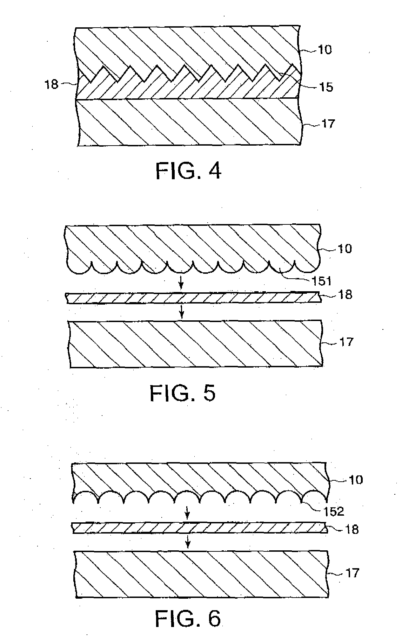

If the screw member is inserted through the attaching recesses 16 of the base plate 10 and is screwed with the heat radiation member 17, the base plate 10 is pressurized to one surface of the heat conduction sheet 18. By doing this, the heat conduction sheet 18 and heat radiation member 17 are adhered closely to each other in the state that the plurality of projections 15 of the base plate 10 are pushed into the heat conduction sheet 18 (refer to Fig. 4).

By use of this constitution, the base plate 10 incorporating the semiconductor element 12, as shown in Fig. 2, is put on the heat radiation member 17 via the heat conduction sheet 18 and is joined and attached to the heat radiation member 17 using the screw member (not shown). Then, the plurality of projections 15, as shown in Fig. 4, make contact with and are pressed to one surface of the heat conduction sheet 18 and are pushed into the surface of the heat conduction sheet 18, thus the base of the plurality of projections 15 is adhered closely to one surface of the heat conduction sheet 18. By doing this, the base plate 10 is thermally coupled with the heat radiation member 17 via the heat conduction sheet 18.

Here, the heat transfer area (contact area) between the base plate 10 and the heat conduction sheet 18 is the area of the portion including the surfaces of the plurality of projections 15 of the attaching surface 10A of the base plate 10, which is larger than the area of the attaching surface. The heat transferred from the semiconductor element 12 to the base plate 10 is transferred efficiently from the portion including the surfaces of the plurality of projections 15 of the attaching surface to the heat conduction sheet 18, is led furthermore to the heat radiation member 17 via the heat conduction sheet 18, and then is radiated. Thereby, the semiconductor element 12 is controlled in heat.

When the heat conduction sheet 18 is formed by a metallic material, the heat transfer area between and the heat conduction sheet 18 and the base plate 10 is increased and furthermore the electric conduction blocking of the base plate 10 can be kept small. Therefore, the semiconductor element 12 mounted on the base plate 10 can keep a higher-performance in electric property.

In the aforementioned attaching structure of the component for mounting the heating element, the base plate 10 is equipped with the plurality of projections 15 formed on the attaching surface 10A, and the base plate 10 is attached to the heat radiation member 17 via the heat conduction sheet 18 formed by a softer material than that of the base plate 10.

Therefore, if the base plate 10 is attached to the heat radiation member 17 on the attaching surface via the heat conduction sheet 18, the plurality of projections 15 of the attaching surface are pushed into the heat conduction sheet 18 and the base plate 10 is thermally coupled with the heat radiation member 17 via the heat conduction sheet 18. The heat transfer area between the base plate 10 and the heat conduction sheet 18 is the area of the attaching surface including the surface area including the outer peripheral walls of the plurality of projections 15, and the heat transfer area can be increased without increasing the area of the attaching surface of the base plate 10. As a result, the attaching structure of the component for mounting the heating element mentioned above can improve the heat radiation efficiency while downsizing of the base plate 10 is secured.

In the embodiment aforementioned, the case that the plurality of projections 15 in the quadrangular pyramid shape is formed on the attaching surface of the base plate 10 is explained. However, the present invention is not limited to it and the projections formed on the attaching surface of the base plate 10 can be formed in various shapes such as the polygonal pyramid shape including a triangular pyramid and higher, conical shape, curved shape, needle shape, and ring shape and similar effective good results are expected.

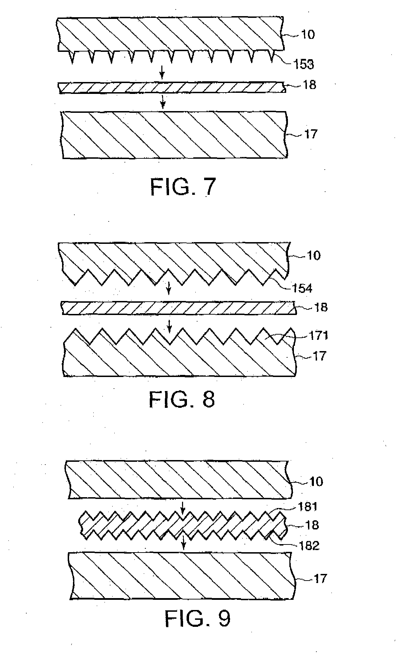

On the attaching surface of the base plate 10, for example, a plurality of projections 151 projected in a curved shape as shown in Fig. 5, a plurality of projections 152 in a circular ring shape as shown in Fig. 6, or a plurality of projections 153 in a rectangular ring shape as shown in Fig. 7 may be installed.

The present invention is not limited to the embodiment aforementioned and can be structured as shown in Figs- 8 to 13 and similar effective good results are expected. Hereinafter, those embodiments will be explained. However, for each of the embodiments shown in Figs. 8 to 13, the same numerals are assigned to the same portions as the those shown in Figs. 1 to 4 and the detailed explanation will be omitted.

### Embodiment 2

In the embodiment shown in Fig. 8, the base plate 10 is equipped with a plurality of projections 154, for example, in the quadrangular pyramid shape on the attaching surface. Further, the heat radiation member 17 is equipped with a plurality of projections 171, for example, in the quadrangular pyramid shape on the attaching surface to which the base plate 10 is attached- And, the heat conduction sheet 18 is held between the plurality of projections 154 and 171 of the base plate 10 and heat radiation member 17. In this embodiment, the heat conduction sheet 18 is formed by a softer material than the materials of both base plate 10 and heat radiation member 17.

The heat conduction sheet 18 is put on the plurality of projections 171 of the heat radiation member 17 and the plurality of projections 154 of the base plate 10 are put thereon. And, as mentioned above, the base plate 10 is attached to the heat radiation member 17 by the screw member (not shown). By doing this, the heat conduction sheet 18 is adhered closely to the base plate 10 and heat radiation member 17 between them in the state that the plurality of projections 154 and 171 of the two are pushed in both surfaces of the heat conduction sheet 18.

As a result, the heat transfer area between the attaching surface of the base plate 10 and the heat conduction sheet 18 is the area of the attaching surface including the surface area including the outer peripheral walls of the plurality of projections 154. Further, the heat transfer area between the attaching surface of the heat radiation member 17 and the heat conduction sheet 18 is the area of the attaching surface including the surface area including the outer peripheral walls of the plurality of projections 171. The heat transfer areas are larger than the respective areas of the attaching surface of the base plate 10 and the attaching surface of the heat transfer member 17- Therefore, according to the attaching structure of the component for mounting the heating element, the heat conduction property between the part base plate 10 and the heat conduction sheet 18 and the heat conduction property between the heat conduction sheet 18 and the heat radiation member 17 are improved and better heat conduction properties can be obtained.

### Embodiment 3

Further, in the embodiment shown in Fig. 9, the heat conduction sheet 18 is formed by a harder material than the materials of the base plate 10 and heat radiation member 17- On both surfaces of the heat conduction sheet 18, for example, a plurality of projections 181 and 182 in the quadrangular pyramid shape are formed in correspondence to and opposite to the attaching surface of the base plate 10 and the attaching surface of the heat radiation member 17.

The heat conduction sheet 18 is arranged between the base plate 10 and the heat radiation member 17, and the base plate 10 and the heat radiation member 17 are attached by the screw member (not shown). Then, the heat conduction sheet 18 is adhered closely to the base plate 10 and heat radiation member 17 therebetween in the state that the plurality of projections 181 and 182 of both surfaces of the heat conduction sheet 18 make contact with the attaching surface of the base plate 10 and the attaching surface of the heat radiation member 17 and are pushed respectively into them.

As a result, the heat transfer area between the attaching surface of the base plate 10 and the heat conduction sheet 18 is the area of the attaching surface including the surface area including the outer peripheral walls of the plurality of projections 181 of the heat conduction sheet 18. Further, the heat transfer area between the attaching surface of the heat radiation member 17 and the heat conduction sheet 18 is the area of the attaching surface including the surface area including the outer peripheral walls of the plurality of projections 182 of the heat conduction sheet 18. The heat transfer areas are larger than the respective areas of the attaching surface of the base plate 10 and the attaching surface of the heat radiation member 17 and good heat conduction properties can be obtained-Embodiment 4

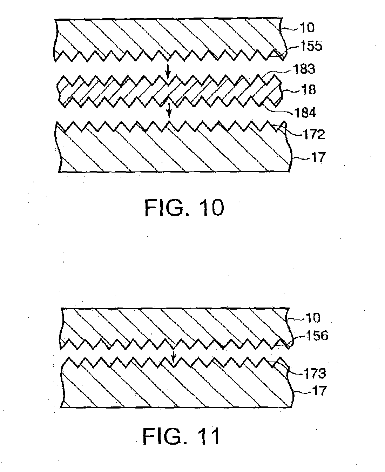

In the embodiment shown in Fig. 10, a plurality of projections 155 and 172 in the quadrangular pyramid shape, for example, are formed on the attaching surface of the base plate 10 and the attaching surface of the heat radiation member 17, respectively. Further, a plurality of projections 183 and 184 in the quadrangular pyramid shape, for example, are formed on both surfaces of the heat conduction sheet 18 in correspondence to the plurality of projections 155 and 172 of the base plate 10 and heat radiation member 17.

The heat conduction sheet 18 is put on the heat radiation member 17 so that the plurality of projections 184 on one surface of the heat conduction sheet 18 may be fit into the plurality of projections 172 of the heat radiation member 17 so as to mate with each other. Further, the base plate 10 is put on the heat conduction sheet 18 so that the plurality of projections 155 of the base plate 10 may be fit into the plurality of projections 183 of the other surface of the heat conduction sheet 18 so as to mate with each other. And, if the base plate 10 is attached to the heat radiation member 17 by the screw member (not shown) as mentioned above, the heat conduction sheet 18 is adhered closely to the base plate 10 and heat radiation member 17 between them in the state that the plurality of projections 184 and 183 of both surfaces of the heat conduction sheet 18 mate with the plurality of projections 172 and 155 of the heat radiation member 17 and base plate 10.

As a result, the heat transfer area of the heat conduction sheet 18 on the attaching surface of the base plate 10 is the area of the attaching surface including the surface area including the outer peripheral walls of the plurality of projections 155. Further, the heat transfer area of the heat conduction sheet 18 on the attaching surface of the heat radiation member 17 is the area of the attaching surface including the surface area including the outer peripheral walls of the plurality of projections 172. The heat transfer areas are larger than the respective areas of the attaching surface of the base plate 10 and the attaching surface of the heat transfer member 17 and good heat conduction properties can be obtained.

### Embodiment 5

In the embodiment shown in Fig. 11, a plurality of projections 156 and 173 in the quadrangular pyramid shape, for example, are formed on the attaching surface of the base plate 10 and the attaching surface of the heat radiation member 17, respectively. The base plate 10 is attached and adhered closely to the heat radiation member 17 by the screw member (not shown) in the state that the plurality of projections 156 of the base plate 10 are fit into the plurality of projections 173 of the heat radiation member 17 so as to mate with each other.

Thereby, the attaching surface of the base plate 10 is adhered closely and thermally coupled to the attaching surface of the heat radiation member 17.

As a result, the heat transfer area of the base plate 10 to the heat radiation member 17 is the area of the attaching surface including the surface area including the outer peripheral walls of the plurality of projections 156. The heat transfer area is larger than the area of the attaching surface, so that a good heat conduction property can be obtained.

### Embodiment 6

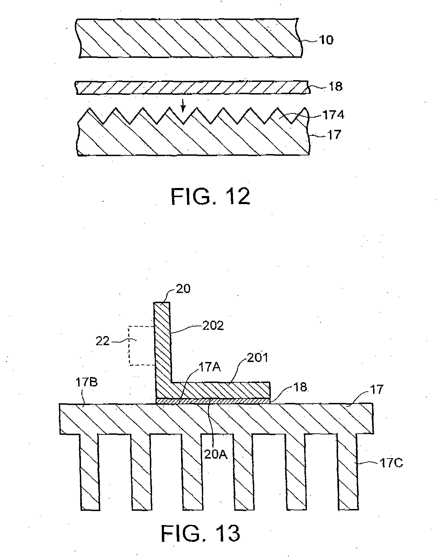

In the embodiment shown in Fig. 12, the heat radiation member 17 includes a plurality of projections 174 formed on the attaching surface and the base plate 10 is attached to the heat radiation member 17 via the heat conduction sheet 18 formed by a softer material than that of the heat radiation member 17.

By doing this, the plurality of projections 174 of the attaching surface of the heat radiation member 17 are pushed into the heat conduction sheet 18 and the base plate 10 is thermally coupled with the heat radiation member 17 via the heat conduction sheet 18. The heat transfer area between the heat radiation member 17 and the heat conduction sheet 18 is spread more than the area of the attaching surface of the heat radiation member 17 due to the surfaces of the plurality of projections 174, thus the heat conduction property between the heat radiation member 17 and the heat conduction sheet 18 can be improved. As a result, in the attaching structure of the component for mounting the heating element, downsizing of the base plate 10 is secured and the heat radiation efficiency can be improved.

### Embodiment 7

In the embodiment shown in Fig. 13, the component for mounting the heating element 20 with an L-shaped section is attached to the heat radiation member 17 via the heat conduction sheet 18. Similarly to the other embodiments aforementioned, the component for mounting the heating element 20 is attached to the heat radiation member 17 by the screw member (not shown). The component for mounting the heating element 20 and heat radiation member 17 include, similarly to the embodiment shown in Fig. 8, a plurality of projections (not shown) formed respectively on the attaching surfaces 20A, 17A thereof. Further, the heat conduction sheet 18 is composed of a softer material than those of the component for mounting the heating element 20 and heat radiation member 17. The heat radiation member 17 has a plurality of heat radiation fins 17C formed on a base body 17B.

Further, the heating element 22 is mounted, for example, on a portion 202 which is different from an attaching portion 201 which the component for mounting the heating element 20 is attached to the heat radiation member 17. The heating element 22 may be mounted to the component for mounting the heating element 20 before attaching the component for mounting the heating element 20 to the heat radiation member 17 or after attaching the component for mounting the heating element 20 to the heat radiation member 17. By use of the attaching structure of the component for mounting the heating element, the attaching structure of the component for mounting the heating element with the heat radiation efficiency improved can be obtained.

Further, in the embodiment shown in Figs. 8 to 13, the shapes of the plurality of projections 154 (155, 156), 171 (172, 173), 181, 182 (183, 184), and 174 are not limited to the quadrangular pyramid shape, and various shapes such as the polygonal pyramid shape including a triangular pyramid and higher, conical shape, curved shape, needle shape, and ring shape may be used, and similar effective good results are expected.

Further, in the embodiments 1 to 6, the case that the component for mounting the heating element is applied to the semiconductor package is explained. However, the present invention is not limited to it and a component for mounting a heating element mounting various electronic parts as a heating element can be applied and effective good results can be expected similarly.

Accordingly, the present invention is not limited to the embodiments aforementioned and can be modified variously within a scope of the invention at the practice stage. Furthermore, the embodiments aforementioned include the inventions at various stages and various inventions can be extracted by an appropriate combination of a plurality of disclosed constituent elements.

For example, even if some constituent elements are deleted from the whole constituent elements indicated in the embodiments, when the problems described in the column of "Problems to be Solved by the Invention" can be solved and the effects described in the column of "Effects of the Invention" can be obtained, the constitution with the constituent elements deleted can be extracted as an invention.

### INDUSTRIAL APPLICABILITY

The attaching structure of the component for mounting the heating element of the present invention can spread the heat transfer area of the attaching surface of the component for mounting the heating element or the heat radiation member, and can be applied to a use of mounting of the heating element required to have a high heat radiation efficiency.

## Claims

1. An attaching structure of a component for mounting a heating element comprising:
a component for mounting a heating element to mount a heating element, the component for mounting the heating element having an attaching surface with a plurality of projections;
a heat radiation member thermally coupled to the component for mounting the heating element; and
a heat conduction sheet formed by a softer material than that of the component for mounting the heating element and arranged between the attaching surface of the component for mounting the heating element and the heat radiation member.

2. The attaching structure of the component for mounting the heating element according to claim 1, wherein the plurality of projections of the component for mounting the heating element are installed overall the attaching surface.

3. An attaching structure of a component for mounting a heating element comprising
a component for mounting a heating element to mount a heating element, the component for mounting the heating element having an attaching surface with a plurality of projections;
a heat radiation member having an attaching surface with a plurality of projections and thermally coupled to the component for mounting the heating element; and
a heat conduction sheet arranged between the plurality of projections of the component for mounting the heating element and the plurality of projections of the heat radiation member, and formed by a softer material than those of the component for mounting the heating element and the heat radiation member.

4. An attaching structure of a component for mounting a heating element comprising:
a component for mounting a heating element to mount a heating element, the component for mounting the heating element having a attaching surface;
a heat radiation member having a attaching surface and thermally coupled to the attaching surface of the component for mounting the heating element; and
a heat conduction sheet arranged between the component for mounting the heating element and the heat radiation member, and formed by a harder material than those of the component for mounting the heating element and the heat radiation member, and the heat conduction sheet having a plurality of projections formed on both surfaces to face to the attaching surface of the component for mounting the heating element and the attaching surface of the heat radiation member.

5. An attaching structure of a component for mounting a heating element comprising:
a component for mounting a heating element to mount a heating element, the component for mounting the heating element having an attaching surface with a plurality of projections;
a heat radiation member having an attaching surface with a plurality of projections and thermally coupled to the attaching surface of the component for mounting the heating element; and
a heat conduction sheet arranged between the attaching surface of the component for mounting the heating element and the attaching surface of the heat radiation member, and having a plurality of projections fit to the plurality of projections of the component for mounting the heating element and the plurality of projections of the heat radiation member.

6. The attaching structure of the component for mounting the heating element according to claim 5, wherein the plurality of projections of the component for mounting the heating element are installed overall the attaching surface of the component for mounting the heating element, the plurality of projections of the heat radiation member are installed overall the attaching surface of the heat radiation member, and the plurality of projections of the heat conduction sheet are installed overall both surfaces of the heat conduction sheet.

7. An attaching structure of a component for mounting a heating element comprising:
a component for mounting a heating element to mount a heating element, the component for mounting the heating element having an attaching surface with a plurality of projections; and
a heat radiation member having an attaching surface with a plurality of projections and thermally coupled to the component for mounting the heating element, and the plurality of projections of the component for mounting the heating element being fit with the plurality of projections of the heat radiation member.

8. The attaching structure of the component for mounting the heating element according to claim 7, wherein the plurality of projections of the component for mounting the heating element and the plurality of projections of the heat radiation member are installed overall the respective attaching surfaces.

9. An attaching structure of a component for mounting a heating element comprising:
a component for mounting a heating element to mount a heating element, the component for mounting the heating element having a attaching surface;
a heat radiation member having a attaching surface with a plurality of projections and thermally coupled to the component for mounting the heating element; and
a heat conduction sheet arranged between the component for mounting the heating element and the heat radiation member and being formed by a softer material than that of the heat radiation member.

10. The attaching structure of the component for mounting the heating element according to any one of claims 1, 3, 4, 5, and 9, wherein the heat conduction sheet is formed by a metallic material.

11. The attaching structure of the component for mounting the heating element according to any one of claims 1, 3, 4, 5, 7, and 9, wherein the component for mounting the heating element is a semiconductor package.

## Amended claims

### Amended claims under Art. 19.1 PCT

1. An attaching structure of a component for mounting a heating element comprising
a component for mounting a heating element to mount a heating element, the component for mounting the heating element having an attaching surface with a plurality of projections;
a heat radiation member; and
a heat conduction sheet formed by a softer material than that of the component for mounting the heating element and arranged between the attaching surface of the component for mounting the heating element and the heat radiation member, and the plurality of projections of the component for mounting the heating element being pushed into the heat conduction sheet.

2. The attaching structure of the component for mounting the heating element according to Claim 1, wherein the plurality of projections of the component for mounting the heating element are installed overall the attaching surface.

3. An attaching structure of a component for mounting a heating element comprising:
a component for mounting a heating element to mount a heating element, the component for mounting the heating element having an attaching surface with a plurality of projections;
a heat radiation member having an attaching surface with a plurality of projections: and
a heat conduction sheet arranged between the attaching surface of the component for mounting the heating element and the attaching surface of the heat radiation member and formed by a softer material than those of the component for mounting the heating element and the heat radiation member, and the plurality of projections of the component for mounting the heating element and the plurality of projections of the heat radiation being pushed into the heat conduction sheet.

4. An attaching structure of a component for mounting a heating element comprising:
a component for mounting a heating element to mount a heating element and the component for mounting the heating element having a attaching surface;
a heat radiation member having a attaching surface; and
a heat conduction sheet arranged between the attaching surface of the component for mounting the heating element and the attaching surface of the heat radiation member and formed by a harder material than those of the component for mounting the heating element and the heat radiation member, and the heat conduction sheet having a plurality of projections pushed into the attaching surface of the component for mounting the heating element and a plurality of projections pushed into the attaching surface of the heat radiation member.

5. An attaching structure of a component for mounting a heating element comprising:
a component for mounting a heating element to mount a heating element and the component for mounting the heating element having a attaching surface;
a heat radiation member having a attaching surface with a plurality of projections; and
a heat conduction sheet arranged between the attaching surface of the component for mounting the heating element and the attaching surface of the heat radiation member and formed by a softer material than that of the heat radiation member, and the plurality of projections of the heat radiation member being pushed into the heat conduction sheet.

6. The attaching structure of the component for mounting the heating element according to any one of claims 1, 3, 4, and 5, wherein the plurality of projections are in a polygonal pyramid shape, a conical shape, a curved shape, a needle shape, or a ring shape.

7. The attaching structure of the component for mounting the heating element according to any one of claims 1, 3, 4, and 5, wherein the component for mounting the heating element makes face-contact with the heat conduction sheet and the heat conduction sheet makes face-contact with the heat radiation member.

8. An attaching structure of a component for mounting a heating element comprising:
a component for mounting a heating element to mount a heating element and the component for mounting the heating element having an attaching surface with a plurality of projections;
a heat radiation member having an attaching surface with a plurality of projections; and
a heat conduction sheet arranged between the attaching surface of the component for mounting the heating element and the attaching surface of the heat radiation member, and having a plurality of projections fit to the plurality of projections of the component for mounting the heating element and the plurality of projections of the heat radiation member:
wherein the plurality of projections of the component for mounting the heating element, the plurality of projections of the heat radiation member, and the plurality of projections of the heat conduction sheet are in a polygonal pyramid shape, a conical shape, a curved shape, a needle shape, or a ring shape.

9. The attaching structure of the component for mounting the heating element according to Claim 8, wherein the plurality of projections of the component for mounting the heating element are installed overall the attaching surface of the component for mounting the heating element, and the plurality of projections of the heat radiation member are installed overall the attaching surface of the heat radiation member, and the plurality of projections of the heat conduction sheet are installed overall both surfaces of the heat conduction sheet.

10. An attaching structure of a component for mounting a heating element comprising:
a component for mounting a heating element to mount a heating element and the component for mounting the heating element having an attaching surface with a plurality of projections; and
a heat radiation member having an attaching surface with a plurality of projections fit to the plurality of projections of the component for mounting the heating element
wherein the plurality of projections of the component for mounting the heating element and the plurality of projections of the heat radiation member are in a polygonal pyramid shape, a conical shape, a curved shape, a needle shape, or a ring shape.

11. The attaching structure of the component for mounting the heating element according to claim 10, wherein the plurality of projections of the component for mounting the heating element and the plurality of projections of the heat radiation member are installed overall the respective attaching surfaces.

12. The attaching structure of the component for mounting the heating element according to any one of claims 1, 3, 4, 5, and 8, wherein the heat conduction sheet is formed by a metallic material.

13. The attaching structure of the component for mounting the heating element according to any one of claims 1, 3, 4, 5, 8, and 10, wherein the component for mounting the heating element is a semiconductor package.
